# EUROPEAN PATENT SPECIFICATION

(11) **EP 2 360 897 B1**
(45) Date of publication and mention of the grant of the patent: **20.02.2013**
(21) Application number: 11150242.3
(22) Date of filing: 05.01.2011
(51) Int. Cl.: H04M 1/02

(54) **Housing structure for a portable terminal.**
Gehäuseaufbau für ein tragbares Gerät.
Structure de logement pour terminal portable.

(30) Priority: 11.02.2010 KR 20100012620
(43) Date of publication of application: 24.08.2011
(73) Proprietor: Samsung Electronics Co., Ltd., Suwon-si, Gyeonggi-do, 443-742 (KR)
(72) Inventor: Kim, Dong-Hak, Suwon-si, Gyeonggi-do (KR); Park, Chan-Seob, Suwon-si, Gyeonggi-do (KR); Lee, Dong-Il, Suwon-si, Gyeonggi-do (KR); Shin, Min-Seok, Suwon-si, Gyeonggi-do (KR)
(74) Representative: van Westenbrugge, Andries

(56) References cited:
- EP-A2- 1 096 758
- FR-A3- 2 737 837
- US-A1- 2009 215 412
- US-A1- 2010 066 219

## Description

### BACKGROUND OF THE INVENTION

### 1. Field of the Invention:

The present invention relates to a portable terminal. More particularly, the present invention relates to a coupling structure of cover members constituting a housing of a portable terminal.

### 2. Description of the Related Art:

A portable terminal refers to a device carried by a user, which allows using various functions including telecommunication, schedule management, playback of multimedia files, gaming, an electronic dictionary, and the like, and a wireless telecommunication terminal may be an exemplary device thereof. Recently, it has been possible to embody a service provided in a real-time basis, such as a wireless Internet, transmission of video files, broadcasting of digital multimedia, and the like, or a communication of bulk information files using a wireless telecommunication terminal.

With the development of these technologies, a user can sufficiently use a variety of functions of the wireless telecommunication terminal or services provided by the same with just one unit of the wireless telecommunication terminal. In other words, besides the voicemail or the multimedia service provided from wireless telecommunication service providers, in the area where a wireless Internet service is available, the user can access the Internet through his/her wireless telecommunication terminal without connecting to the wireless telecommunication service network. Such a telecommunication function allows the user to download whatever contents he/she wants to have through the internet at low cost.

Meanwhile, such wireless telecommunication terminals come in different forms where they are either made of one piece of a housing or a pair of housings pivotably or slidably coupled to each other. The respective housings have constructions in which a front cover and a rear cover are opposingly joined together so as to install circuit devices therein with ease. Typically, the front cover and the rear cover are coupled with each other using a fastening member, such as a screw. Here, in order to prevent the joining portions of the edges from swelling, clamping structures like a plurality of hooks are disposed along the edges of the front and the rear covers.

These clamping structures for the front and rear covers are durably provided without using the screws as to stably maintain the clamping state against impacts caused in a case of dropping the wireless telecommunication terminal on an object, or the like. However, when the front cover and the rear cover need to be separated for repair, such clamping structures become troublesome. In addition, the appearance of the terminal may be damaged in the case of using a tool to separate the clamping structures. Moreover, when an excessive force to separate the front and rear covers is applied during repair, the clamping structures, such as a hook, and the like can be damaged. In addition, it should be noted that after the front and rear covers are joined and secured to each other with the screws, separate finishing works are required to hide the screws, which makes the assembly work burdensome and causes difficulties in polishing the appearance of the terminal.

Document US 2009/215412 A1 describes a housing of portable electronic device including an upper housing and a lower housing, with in between a protecting component. The protecting component is assembled between the upper housing and the lower housing for preventing dust and vapor from entering the electronic device. Document EP 1 096 758 A2 discloses a portable terminal unit including a box constituting a unit body. The box comprises a first case and a second case, which can be coupled through ribs and grooves. Document FR 2 737 837 A3 discloses a housing having two parts comprising flexible material, attached to each other by a snapping action.

Therefore, a need exists for a portable terminal capable of stably maintaining a clamping state of a front cover and a rear cover, having a structure in which the front and rear covers can be easily separated.

### SUMMARY OF THE INVENTION

An aspect of the present invention is to address at least the above-mentioned problems and/or disadvantages and to provide at least the advantages described below. Accordingly, an aspect of the present invention is to provide a portable terminal capable of stably maintaining a clamping state of a front cover and a rear cover, having a structure in which the front and rear covers can be easily separated.

Another aspect of the present invention is to provide a portable terminal having a structure that can be easily assembled by joining the front and rear covers constituting a housing by means of a case member made from an extrusion process.

Still another aspect of the present invention is to provide a portable terminal having a structure in which the front and rear covers can be durably assembled by joining the front and rear covers constituting a housing by means of a case member made from an extrusion process.

In accordance with an aspect of the present invention, a portable terminal is provided. The portable terminal includes a housing having a front cover, and a rear cover opposingly coupled with the front cover, a guide rail formed on the opposite lateral surfaces of the front cover and extending in a longitudinal direction of the front cover, a guide groove formed between the guide rail and the lateral surface of the front cover and open to a forward direction of the front cover, and a case member enclosing at least the opposite lateral surfaces and the rear surface of the housing, wherein the case member includes a rail groove to receive the guide rail and a guide rib to be engaged with the guide groove, and wherein the front cover is pressed in a predefined direction to closely contact the rear cover.

The portable terminal may include a display window disposed at a front surface of a front cover, a clamping groove formed at an upper or lower side of the display window, and a clamping protrusion formed at the case member to be engaged with the clamping groove, wherein the case member further includes a band member for enclosing the upper or lower side of the display window, and wherein the clamping protrusion is formed at the inner surface of the band member.

The clamping groove and the clamping protrusion may be formed in a T-shaped cross-section.

The rail grooves may be recessed at the inner wall of the case member facing each other at the opposite sides of the housing. The terminal may further be provided with grooves which are formed at the inner wall of the rail groove disposed at the front and rear sides of the housing and at least partially enclosed by the guide rib. A portion of the guide rail may be engaged with a groove positioned at the front side of the housing among the grooves.

In addition, the terminal may further include a key hole formed on at least one lateral surface of the case member, and a key member received in the key hole to be projected or retreated from the lateral surface of the case member.

In the terminal as constructed hereinabove, it is desirable that the case member further includes a stepped surface formed at one side of the rail groove and designed to support the rear cover from the rearward direction of the housing being in close contact with the front cover.

Further, the case member may be manufactured from an extrusion process and be slidably coupled from the upper side to the lower side of the housing.

Therefore, it should be appreciated that the portable terminal in accordance with exemplary embodiments of the present invention can securely join the front and rear covers by means of the case member without using a fastening member, such as a separate screw, a hook, or a clamping structure. Since the case member can be joined or separated in a slide manner, it is advantageous in that the front and rear covers can be assembled or dissembled with ease. Besides, when the case member is made with a metallic material through an extrusion process, the case member can constitute the corner portion of the terminal housing, which makes it possible to minimize the damage of the front and rear covers when impacts caused in a case of dropping the wireless telecommunication terminal on an object, or the like, is applied thereto. Moreover, when a key is disposed on the lateral surface of the terminal housing, it is possible to install the key member without using a double-sided tape, an ultrasonic fusion-deposited protrusion, or the like, thereby leading to an easy assembly thereof.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following detailed description taken in conjunction with the accompanying drawings, in which:

FIG. 1 illustrates an exploded view of a portable terminal according to an exemplary embodiment of the present invention;

FIG. 2 illustrates an assembly of a portable terminal according to an exemplary embodiment of the present invention;

FIG. 3 illustrates an assembled portable terminal according to an exemplary embodiment of the present invention;

FIG. 4 illustrates a partially enlarged view of a case member of a portable terminal according to an exemplary embodiment of the present invention;

FIG. 5 illustrates a cross-sectional view of a portable terminal according to an exemplary embodiment of the present invention;

FIG. 6 illustrates a key member of a portable terminal according to an exemplary embodiment of the present invention; and

FIG. 7 illustrates a coupling of a case member with a front cover of a portable terminal according to an exemplary embodiment of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

By the term "substantially" it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

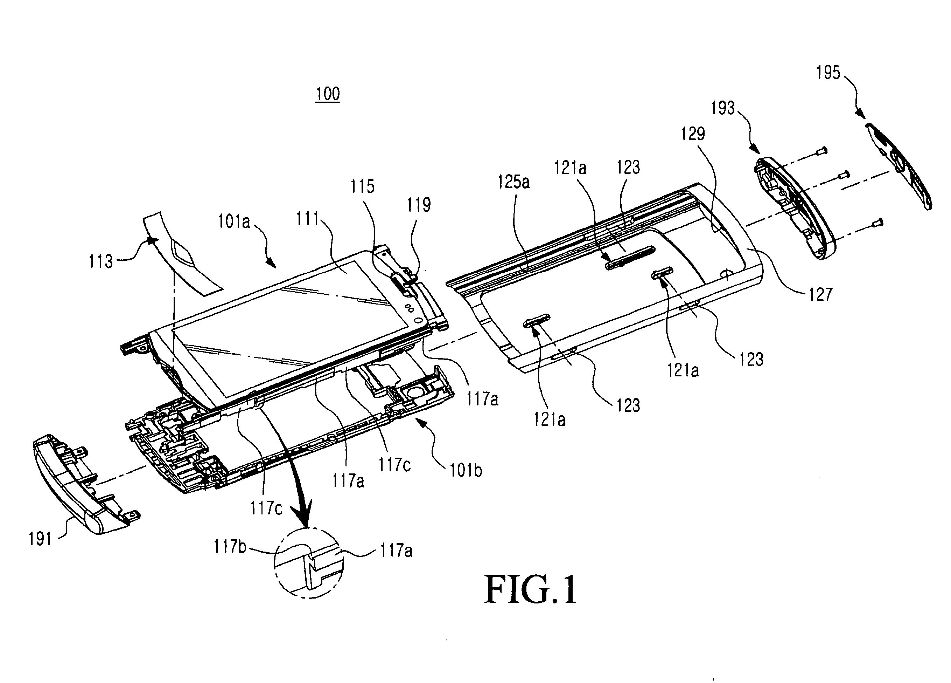

FIGs. 1 through 7, discussed below, and the various exemplary embodiments used to describe the principles of the present disclosure in this patent document are by way of illustration only and should not be construed in any way that would limit the scope of the disclosure. Those skilled in the art will understand that the principles of the present disclosure may be implemented in any suitably arranged communications system. The terms used to describe various embodiments are exemplary. It should be understood that these are provided to merely aid the understanding of the description, and that their use and definitions in no way limit the scope of the invention. Terms first, second, and the like are used to differentiate between objects having the same terminology and are in no way intended to represent a chronological order, unless where explicitly state otherwise. A set is defined as a non-empty set including at least one element.

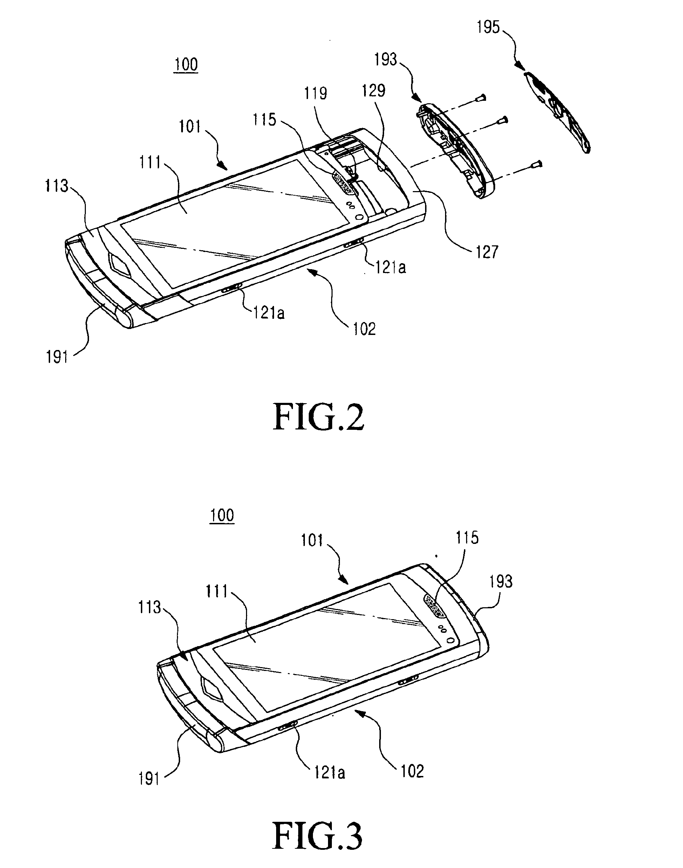

FIG. 1 illustrates an exploded view of a portable terminal according to an exemplary embodiment of the present invention, FIG. 2 illustrates an assembly of a portable terminal according to an exemplary embodiment of the present invention, and FIG. 3 illustrates an assembled portable terminal according to an exemplary embodiment of the present invention.

Referring to FIGs. 1 through 3, a portable terminal 100 includes a housing 101 constructed by joining front and rear covers 101a and 101b, and a case member 102 coupled to enclose at least opposite lateral surfaces of the housing 101. Here, the case member 102 is made from an extrusion process and coupled with the housing 101 in a slide manner, which presses the front cover 101a in a direction to closely contact the same to the rear cover 101b.

The front cover 101a is manufactured by an injection molding method with a synthetic resin material or by a die-casting method using a metallic material, having a display device (not shown) therein. Since the case member 102 is manufactured by the injection molding method and coupled to the housing 101 in a slide manner, it is desirable to form the front cover 101a through the die-casting method, or the like, using a metallic material. The display device is protected by a window 111, and a voice receiver 115 is provided at the upper side of the display device, i.e., the window 111. Meanwhile, a keypad module 113 and a voice transmitter (not shown) are provided at the lower side of the window 111. Formed on the opposite lateral surfaces of the front cover 101a are guide rails 117a to be coupled with the case member 102. At the upper end of the front cover 101a, a coupling groove 119 extends in a sliding direction of the case member 102.

At this moment, each guide rail 117a extends in the longitudinal direction of the front cover 101a at the opposite lateral surfaces of the front cover 101a, and the coupling groove 119 extends from the upper end of the front cover 101a to a location adjacent to the voice receiver 115. In addition, a guide groove 117b is formed between the guide rail 117a and one of the lateral surfaces of the front cover 101a. The guide groove 117b also extends in the longitude direction of the front cover 101a and is open to the forward direction of the front cover 101a.

Meanwhile, a volume adjusting key, a power button, a hot key for switching to either a camera mode or a digital multimedia broadcasting view mode, and the like, may be installed on the opposite lateral surfaces of the terminal. Moreover, dome sheets 117c corresponding to such keys are formed on the opposite lateral surfaces of the front cover 101a. In order to install the dome sheets 117c, a portion of the guide rail 117a may be removed from the opposite lateral surfaces of the front cover 101 a.

The rear cover 101b is joined to the rear surface of the front cover 101a to complete the housing 101. At this point, a portion of the rear cover 101b is removed, which enables a portion of the rear surface of the front cover 101a to be exposed to the rearward direction of the housing 101. Accordingly, a mounting recess for receiving a battery pack (not shown) may be provided at the portion of the rear surface of the front cover 101a exposed to the rearward direction of the housing 101.

Meanwhile, a coupling member 191 is provided at the lower end of the housing 101. The coupling member 191 may be provided with a microphone or an antenna module to constitute a voice transmitter therein. In a state where the front cover 101a and the rear cover 101b are joined together, the coupling member 191 is mounted to enclose the lower end portions of the front cover 101a and the rear cover 101b. Here, the terminal 100 may be provided with a fastening member (not shown) which is penetrated into the front and rear covers (101a, 101b) and coupled with the coupling member 191.

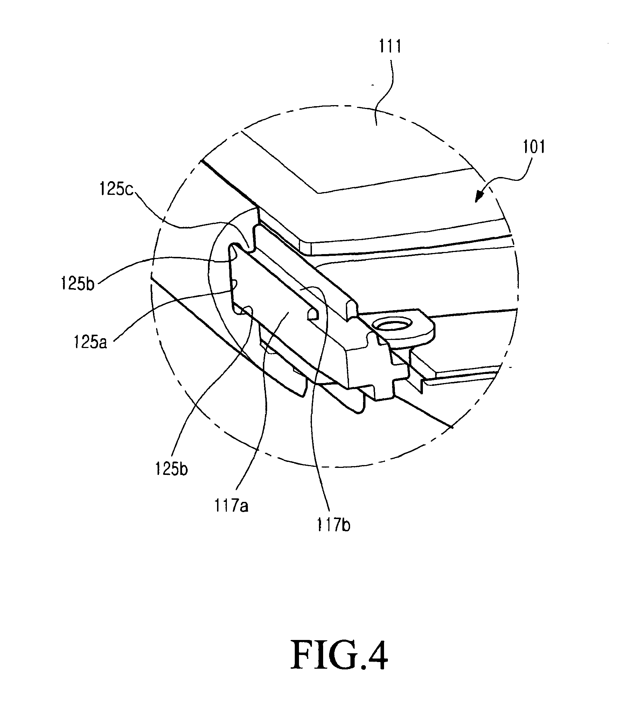

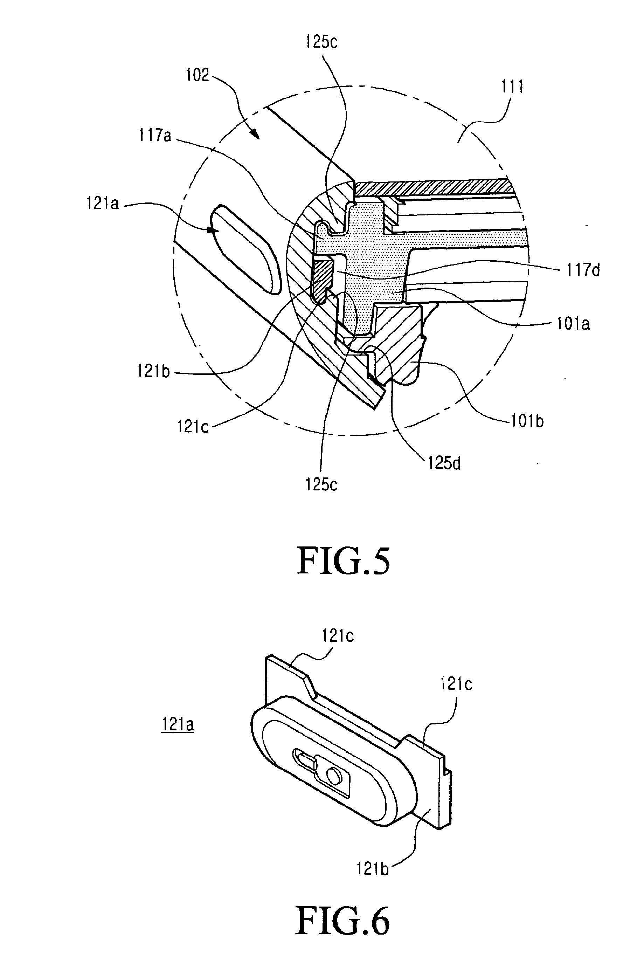

FIG. 4 illustrates a partially enlarged view of a case member of a portable terminal according to an exemplary embodiment of the present invention, and FIG. 5 illustrates a cross-sectional view of a portable terminal according to an exemplary embodiment of the present invention.

Referring to FIGs. 4 and 5, a case member 102 is provided to further enclose opposite lateral surfaces of a housing 101 (i.e., the respective portions of the front and rear surfaces of the housing 101). More particularly, the case member 102 is provided to cover the outer lateral surface of the rear cover 101b. At this point, a portion among the portions enclosing the rear cover 101b is formed with an opening corresponding to the removed portion of the rear cover 101b. Hence, after the case member 102 is assembled, the recess for mounting a battery pack of the terminal 100 is exposed to the outside. In an exemplary implementation, a separate battery pack cover is detachably provided at the opening of the case member 102.

The case member 102 is formed with rail grooves 125a extending in the longitudinal direction at the opposite inner walls thereof, which are facing the opposite lateral surfaces of the housing 101. The rail grooves 125a are designed to receive the respective guide rails 117a to guide the sliding movement of the case member 102 while the case member 102 is being joined with the housing 101. Thereafter, when the case member 102 is completely joined with the housing 101, the rail grooves 125a keep the engagement state with the guide rails 117a. At this moment, the entrance side of the rail groove 125a, that is, the inner side of the case member 102 is formed with a guide rib 125c to be engaged with a guide groove 117b. As the guide rib 125c is formed at the entrance side of the rail groove 125a, the respective inner wall of the rail grooves 125a positioned at the front and rear sides of the housing 101 is provided with a groove 125b, a portion of which is enclosed by the guide rib 125c. A portion of the guide rail 117a is engaged with one of the grooves 125b, which are positioned at the forward direction of the housing 101. The rail groove 125a and the guide rib 125c are respectively engaged with the guide rail 117a and the guide groove 117b to pressurize the front cover 101 a in a direction closely contacting the same to the rear cover 101b.

Meanwhile, a stepped surface 125d supporting the edge portion of the rear cover 101b is provided at the inner surface of the case member 102. In a state where the rear cover 101b is supported by the stepped surface 125d, the rail groove 125a and the guide rib 125c press the front cover 101a, so that the front cover 101a is closely secured to the rear cover 101b. In addition, since the case member 102 pressurizes the front cover 101a in a direction closely contacting the rear cover 101b, the case member 102 is closely brought into contact with the front cover 101a, which makes it possible to maintain a consistent appearance with the front cover 101 a at the opposite sides of the front cover 101 a.

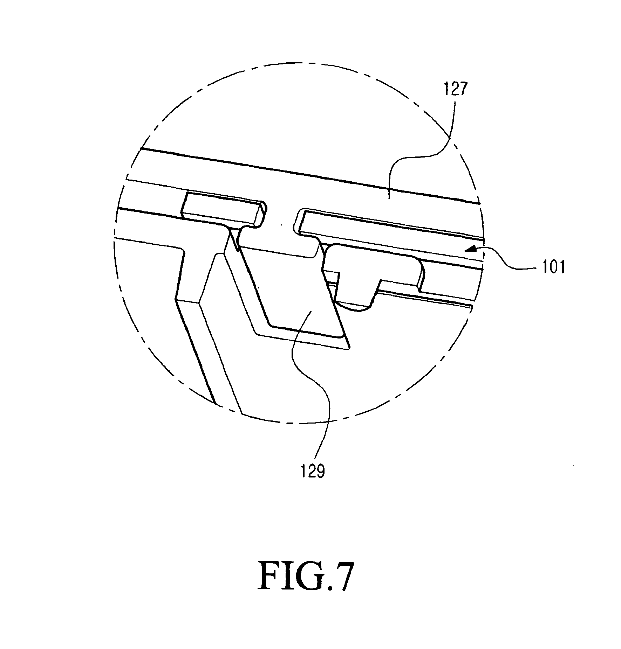

FIG. 7 illustrates a coupling of a case member with a front cover of a portable terminal according to an exemplary embodiment of the present invention.

Referring to FIG. 7, the case member 102 is formed with a coupling protrusion 129, which is engaged with the coupling groove 119 of the front cover 101a. The case member 102 is provided with a band member 127 enclosing the upper side of the front cover 101a. The coupling protrusion 129 is formed at the inner surface of the band member 127, having a T-shaped cross-section. As the coupling protrusion 129 is engaged with the coupling groove 119, the band member 127 is closely contacted to the front cover 101a. In the same manner that the rail groove 125a and the guide rib 125c closely press the front cover 101a, so as to make the case member 102 show a consistent appearance with the front cover 101a, the band member 127 is also able to maintain a consistent appearance with the front surface of the front cover 101a as the coupling protrusion 129 is engaged with the coupling groove 119.

Referring back to FIGs. 1 and 2, an exemplary construction is illustrated in which the case member 102 is joined from the upper side to the lower side of the housing 101. However, it can be understood by those skilled in the art that the case member 102 may be slidably joined from the lower side to the upper side of the housing 101, provided that the coupling groove 119 can be formed at the lower side of the window 111, i.e., a portion where the keypad module 113 is installed. At this point, it is obvious that the coupling member 191 should be modified into a construction to be coupled at the upper end of the housing 101.

As mentioned above, the terminal 100 may be provided with a volume adjusting key, a power button, a hot key for switching to either a camera mode or a digital multimedia broadcasting view mode, or the like (referred to as a "function key" hereinafter). In order to install such a function key, the case member 102 is formed with a key hole 123. Each key hole 123 is provided with a key member 121a, which can be projected or retreated from the lateral surface of the case member 102.

The case member 102 as such can be made from an extrusion process with a metallic material. Although it requires finishing works at the corner portion or machining works to form a key hole 123, or the like, after the extrusion process, it is easy to mass produce products with uniform dimensions by manufacturing the case member 102 through the extrusion process.

FIG. 6 illustrates a key member of a portable terminal according to an exemplary embodiment of the present invention.

Referring to FIG. 6, a key member 121a is formed with a supporting part 121b extending outwards in a predefined length at its base. The key member 121a may be provided with a coupling piece 121c projecting from the edge of the supporting part 121b. When the key member 121a is installed in the key hole 123, the supporting part 121b is supported against the wall surface of the rail groove 125a. If the key member 121a is made from an elastomeric material, such as urethane or silicone, it can firmly deliver the pressing operation by the user to the dome sheet 117c and may be stably positioned in the key hole 123 without any movements. The key member 121 a may be painted on its outer surface or provided with injection moldings or metallic pieces, or the like thereon, so as to maintain a uniform appearance with the case member 102. The coupling piece 121c is engaged with the rail groove 125a, and the groove 125b is positioned at the rear side of the housing 101 among the grooves 125b, a portion of which is enclosed by the guide rib 125c.

As the supporting part 121b is disposed in the rail groove 125a, the case member 102 can interfere with functions of the guide rail 117a when being joined with the housing 101. To address this issue, each guide rail 117a is formed with an evading hole 117d along the path where the supporting part 121b is passing by while the case member 102 is assembled to the housing 101. In other words, even when the supporting part 121b is positioned within the rail groove 125a, the supporting part 121b maintains its position without interfering with functions of the guide rail 117a.

In a state where the case member 102 is completely joined to the housing 101, a portion of the supporting part 121b is facing the outer wall of the guide rail 117a. As mentioned above, a portion of the guide rail 117a is removed to install the dome sheet 117c, while the key member 121a is disposed correspondingly to the dome sheets 117c. The edge portion of the supporting part 121b is opposing the guide rail 117a and the inner wall of the evading groove 117d, and the supporting part 121b is supported by the inner wall of the evading groove 117d to restore the key member 121a to the initial position, that is, a position protruded to the outer lateral surface of the case member 102.

Consequently, it should be noted that the key member 121a can be installed only by arranging it in the key hole 123 and by locating the coupling piece 121c to be engaged with one of the grooves 125b without using a separate double-sided tape or forming a melting bond protrusion.

The terminal 100 may be provided with a connector for charging, or for connecting to a personal computer, a hands free set, a detachable antenna for viewing digital multimedia broadcasting, or the like, or a socket for a memory card or the like. Such a connector (not shown) or a socket (not shown) is provided at the upper end of the housing, which is protected using a separate cap or a cover and opened for its use, if necessary.

In addition to the voice receiver 115, a separate speaker device to be used in a multimedia function can be installed in the housing 101. Holes for outputting the sound of such a speaker device may be disposed at the upper end of the housing 101. At this point, the holes for outputting the sound can be located at the lateral surfaces of the terminal to provide a stereo function, or the like. When the holes for outputting the sound are disposed at the lateral surfaces of the terminal 100, the case member 102 also has to be formed with additional holes for outputting the sound, or opened to expose the holes for outputting the sound of the speaker device.

Since a user opens and uses the connector or the socket according to his/her needs, the upper end portion of the case member 102 is open to the outside. In order to hide the upper end portion of the case member 102, it is coupled with a cover member 193 and a decoration cover 195. The cover member 193 is assembled and secured to the upper end of the housing 101 through a fastening member, such as screws, while being engaged with the upper end of the case member 102. Hence, the case member 102 is secured to the housing 101. Though not shown in the drawings, the cover member 193 may be provided with holes to expose the connector or the socket, and a cap or a cover to open and close such holes. Moreover, although the decoration cover 195 is not required to be installed, it is desirable to attach the decoration cover 195 at the outer side of the cover member 193, so as to hide the screws fixing the cover member 193 and polish the outer appearance of the terminal 100. When the decoration cover 195 is attached to the cover member 193, it is obvious that the decoration cover 195 also has to be formed with holes to expose the connector or the socket.

While the invention has been shown and described with reference to certain exemplary embodiments thereof, it will be understood by those skilled in the art that various changes in form and details may be made therein without departing from the spirit and scope of the invention as defined in the appended claims and their equivalents.

For instance, as mentioned above, the case member can be slidably coupled from the lower side to the upper side of the housing. In this case, the coupling member needs to be a modified structure to be assembled at the upper end of the portable terminal.

Further, in exemplary embodiments of the present invention, a construction of a bar-type terminal is described. However, in case that the terminal is provided with a housing constructed to join the front cover to the rear cover, the construction to couple the front cover with the rear cover is applicable to a folder-type terminal or a slide-type terminal or the like using the case member in accordance with exemplary embodiments of the present invention.

## Claims

1. A portable terminal (100) comprising:
a housing (101) having a front cover (101a) and a rear cover (101b) opposingly coupled with the front cover;
a guide rail (117a) formed on opposing lateral surfaces of the front cover (101a) and extending in a longitudinal direction of the front cover;
a guide groove (117b) formed between the guide rail (117a) and the lateral surface of the front cover (101a) and open to a forward direction of the front cover;
and
a case member (102) coupled to enclose at least the opposite lateral surfaces and the rear surface of the housing (101),
wherein the case member includes a rail groove (125a) to receive the guide rail (117a), a guide rib (125c) to be engaged with the guide groove (117b), and wherein the front cover(101a) is pressed in a predefined direction to closely contact the rear cover (101b).

2. The portable terminal (100) of claim 1 further comprising:
a display window disposed at the front surface of the front cover (101a);
a clamping groove (119) formed at an upper or lower side of the display window; and
a clamping protrusion (129) formed at the case member (102) to be engaged with the clamping groove (119),
wherein the case member further (102) includes a band member (127) for enclosing the upper or lower side of the display window, and wherein the clamping protrusion (129) is formed at the inner surface of the band member.

3. The portable terminal (100) of claim 2, wherein the clamping groove (119) and the clamping protrusion (129) are formed in a T-shaped cross-section.

4. The portable terminal (100) of claim 1, wherein the case member (102) further includes an opening to expose a portion of the rear cover (101b) and encloses a portion of the rear surface of the housing (101).

5. The portable terminal (100) of claim 1, wherein the rail groove (125a) is recessed at inner walls of the case member (102) facing each other at the opposite lateral surfaces of the housing (101).

6. The portable terminal (100) of claim 1 further comprising:
grooves (125b) respectively formed at inner walls of the rail groove (125a) and disposed at the rear and front surfaces of the housing (101) and at least partially enclosed by the guide rib (125c),
wherein a portion of the guide rail (117a) is engaged with a groove (125b) positioned at the front surface of the housing (101) among the grooves.

7. The portable terminal (100) of claim 5 further comprising:
a key hole (123) formed on at least one lateral surface of the case member (102); and
a key member (121a) received in the key hole (123) to be projected or retreated from the lateral surface of the case member (102).

8. The portable terminal (100) of claim 7, wherein the key member (121a) comprises:
a supporting part (121b) extending outwards at its base; and
a coupling piece (121c) projecting from the edge of the supporting part (121b), wherein the supporting part is supported against the wall surface of the rail groove (125a), and wherein the coupling piece (121c) is engaged with a groove (125b) positioned at the rear side of the housing among the grooves (125b).

9. The portable terminal (100) of claim 8, wherein the other portion of the guide rail (117a) is in an opposite position to a portion of the supporting part (121b).

10. The portable terminal (100) in any one of claims 1 to 9, wherein the case member (102) further comprises:
a stepped surface (125d) formed at one side of the rail groove (125a),
wherein the stepped surface (125d) is designed to support the rear cover (101b) from the rearward direction of the housing (101) being in close contact with the front cover (101a).

11. The portable terminal (100) in any one of claims 1 to 9, wherein the case member (102) is slidably coupled from the upper side to the lower side of the housing (101).

12. The portable terminal (100) of claim 11, wherein the upper end of the case member (102) is open to expose the upper end portion of the housing (101).

13. The portable terminal (100) of claim 12 further comprising:
a cover member (193) to be coupled to the upper end of the housing (101), wherein the cover member (193) is designed to secure the case member (102) to the housing (101).

14. The portable terminal (100) of claim 13 further comprising:
a decoration cover (195) to be attached to the outer surface of the cover member (193).

15. The portable terminal (100) of claim 14 further comprising:
at least one connector to be disposed at the upper end of the housing (101), wherein the cover member (193) and the decoration cover (195) further includes holes to expose the connector.

## Patentansprüche

1. Tragbares Endgerät (100), das Folgendes umfasst:
ein Gehäuse (101) mit einer Frontabdeckung (101a) und einer rückseitigen Abdeckung (101b), die gegenüberliegend mit der Frontabdeckung gekoppelt ist;
eine Führungsschiene (117a), die an gegenüberliegenden Seitenflächen der Frontabdeckung (101a) ausgebildet ist und sich in einer Längsrichtung der Frontabdeckung erstreckt;
eine Führungsnut (117b), die zwischen der Führungsschiene (117a) und der Seitenfläche der Frontabdeckung (101a) ausgebildet ist und in einer Vorwärtsrichtung der Frontabdeckung offen ist; und
ein Etui-Element (102), das so gekoppelt ist, dass es mindestens die gegenüberliegenden Seitenflächen und die Rückseite des Gehäuses (101) umschließt,
wobei das Etui-Element eine Schienennut (125a) zum Aufnehmen der Führungsschiene (117a) und eine Führungsrippe (125c), die mit der Führungsnut (117b) in Eingriff zu bringen ist, enthält, und wobei die Frontabdeckung (101a) in eine vorgegebene Richtung gedrückt wird, um einen direkten Kontakt mit der rückseitigen Abdeckung (101b) herzustellen.

2. Tragbares Endgerät (100) nach Anspruch 1, das des Weiteren Folgendes umfasst:
ein Anzeigefenster, das an der Vorderseite der Frontabdeckung (101a) angeordnet;
eine Klemmnut (119), die an einer Ober- oder Unterseite des Anzeigefensters ausgebildet ist; und
einen Klemmvorsprung (129), der an dem Etui-Element (102) ausgebildet ist und mit der Klemmnut (119) in Eingriff zu bringen ist,
wobei das Etui-Element (102) des Weiteren ein Bandelement (127) zum Umschließen der Ober- oder Unterseite der Anzeigefenster enthält, und wobei der Klemmvorsprung (129) an der Innenseite des Bandelements ausgebildet ist.

3. Tragbares Endgerät (100) nach Anspruch 2, wobei die Klemmnut (119) und der Klemmvorsprung (129) einen T-förmigen Querschnitt aufweisen.

4. Tragbares Endgerät (100) nach Anspruch 1, wobei das Etui-Element (102) des Weiteren eine Öffnung enthält, um einen Abschnitt der rückseitigen Abdeckung (101b) frei zu legen, und einen Abschnitt der Rückseite des Gehäuses (101) umschließt.

5. Tragbares Endgerät (100) nach Anspruch 1, wobei die Schienennut (125a) an Innenwänden des Etui-Elements (102) ausgespart ist, die einander an den gegenüberliegenden Seitenflächen des Gehäuses (101) zugewandt sind.

6. Tragbares Endgerät (100) nach Anspruch 1, das des Weiteren Folgendes umfasst:
Nuten (125b), die jeweils an Innenwänden der Schienennut (125a) ausgebildet sind und an der Rück - und der Vorderseite des Gehäuses (101) angeordnet sind und mindestens teilweise durch die Führungsrippe (125c) umschlossen werden,
wobei ein Abschnitt der Führungsschiene (117a) mit einer Nut (125b) in Eingriff steht, die an der Vorderseite des Gehäuses (101) zwischen den Nuten positioniert ist.

7. Tragbares Endgerät (100) nach Anspruch 5, das des Weiteren Folgendes umfasst:
ein Passfederöffnung (123), die in mindestens einer Seitenfläche des Etui-Elements (102) ausgebildet ist;
und
ein Passfederelement (121a), das in der Passfederöffnung (123) aufgenommen ist, um von der Seitenfläche des Etui-Elements (102) hervorzustehen oder zurückgezogen zu werden.

8. Tragbares Endgerät (100) nach Anspruch 7, wobei das Passfederelement (121a) Folgendes umfasst:
einen Stützteil (121b), der sich an seiner Basis auswärts erstreckt; und
ein Kopplungsstück (121c), das vom Rand des Stützteils (121b) hervorsteht, wobei sich der Stützteil an der Wandfläche der Schienennut (125a) abstützt, und wobei das Kopplungsstück (121c) mit einer Nut (125b) in Eingriff steht, die an der Rückseite des Gehäuses zwischen den Nuten (125b) positioniert ist.

9. Tragbares Endgerät (100) nach Anspruch 8, wobei sich der andere Abschnitt der Führungsschiene (117a) in einer gegenüberliegenden Position zu einem Abschnitt des Stützteils (121b) befindet.

10. Tragbares Endgerät (100) nach einem der Ansprüche 1 bis 9, wobei das Etui-Element (102) des Weiteren Folgendes umfasst:
eine gestufte Fläche (125d), die auf einer Seite der Schienennut (125a) ausgebildet ist,
wobei die gestufte Fläche (125d) dafür ausgelegt ist, die rückseitige Abdeckung (101b) aus der rückwärtigen Richtung des Gehäuses (101), das in direktem Kontakt mit der Frontabdeckung (101a) steht, zu stützen.

11. Tragbares Endgerät (100) nach einem der Ansprüche 1 bis 9, wobei das Etui-Element (102) von der Oberseite des Gehäuses (101) her zur Unterseite des Gehäuses (101) hin verschiebbar gekoppelt ist.

12. Tragbares Endgerät (100) nach Anspruch 11, wobei das obere Ende des Etui-Elements (102) offen ist, um den oberen Endabschnitt des Gehäuses (101) frei zu legen.

13. Tragbares Endgerät (100) nach Anspruch 12, das des Weiteren Folgendes umfasst:
ein Abdeckungselement (193), das mit dem oberen Ende des Gehäuses (101) zu koppeln ist, wobei das Abdeckungselement (193) dafür ausgelegt ist, das Etui-Element (102) an dem Gehäuse (101) zu sichern.

14. Tragbares Endgerät (100) nach Anspruch 13, das des Weiteren Folgendes umfasst:
eine Zierabdeckung (195), die an der Außenfläche des Abdeckungselements (193) anzubringen ist.

15. Tragbares Endgerät (100) nach Anspruch 14, das des Weiteren Folgendes umfasst:
mindestens einen Verbinder, der an dem oberen Ende des Gehäuses (101) anzuordnen ist, wobei das Abdeckungselement (193) und die Zierabdeckung (195) des Weiteren Öffnungen enthalten, um den Verbinder frei zu legen.

## Revendications

1. Terminal portable (100) comprenant :
un logement (101) ayant un couvercle avant (101a) et un couvercle arrière (101b) couplé au couvercle avant à l'opposé de celui-ci ;
un rail de guidage (117a) formé sur des surfaces latérales opposées du couvercle avant (101a) et s'étendant dans une direction longitudinale du couvercle avant ;
une rainure de guidage (117b) formée entre le rail de guidage (117a) et la surface latérale du couvercle avant (101a) et ouverte dans une direction vers l'avant du couvercle avant ; et
un organe de boîtier (102) couplé pour renfermer au moins les surfaces latérales opposées et la surface arrière du logement (101),
dans lequel l'organe de boîtier comprend une rainure de rail (125a) pour recevoir le rail de guidage (117a), une nervure de guidage (125c) à mettre en prise avec la rainure de guidage (117b), et dans lequel le couvercle avant (101a) est pressé dans une direction prédéfinie pour entrer en contact étroit avec le couvercle arrière (101b).

2. Terminal portable (100) selon la revendication 1, comprenant en outre :
une fenêtre d'affichage disposée à la surface avant du couvercle avant (101a) ;
une rainure de fixation (119) formée à un côté supérieur ou inférieur de la fenêtre d'affichage ; et
une protubérance de fixation (129) formée à l'organe de boîtier (102) pour se mettre en prise avec la rainure de fixation (119),
dans lequel l'organe de boîtier (102) comprend en outre un organe de bandeau (127) pour renfermer le côté supérieur ou inférieur de la fenêtre d'affichage, et dans lequel la protubérance de fixation (129) est formée à la surface intérieure de l'organe de bandeau.

3. Terminal portable (100) selon la revendication 2, dans lequel la rainure de fixation (119) et la protubérance de fixation (129) ont une coupe transversale en forme de T.

4. Terminal portable (100) selon la revendication 1, dans lequel l'organe de boîtier (102) comprend en outre une ouverture pour exposer une portion du couvercle arrière (101b) et renferme une portion de la surface arrière du logement (101).

5. Terminal portable (100) selon la revendication 1, dans lequel la rainure de rail (125a) est évidée à des parois intérieures de l'organe de boîtier (102) se faisant face entre elles aux surfaces latérales opposées du logement (101).

6. Terminal portable (100) selon la revendication 1, comprenant en outre :
des rainures (125b) formées respectivement à des parois intérieures de la rainure de rail (125a) et disposées aux surfaces arrière et avant du logement (101) et au moins partiellement renfermées par la nervure de guidage (125c),
dans lequel une portion du rail de guidage (117a) est mise en prise avec une rainure (125b) positionnée à la surface avant du logement (101) parmi les rainures.

7. Terminal portable (100) selon la revendication 5, comprenant en outre :
un trou de clé (123) formé sur au moins une surface latérale de l'organe de boîtier (102) ; et
un organe de clé (121a) reçu dans le trou de clé (123) pour se projeter ou se rétracter de la surface latérale de l'organe de boîtier (102).

8. Terminal portable (100) selon la revendication 7, dans lequel l'organe de clé (121a) comprend :
une partie de support (121b) s'étendant vers l'extérieur à sa base ; et
une pièce de couplage (121c) faisant saillie du bord de la partie de support (121b), dans lequel la partie de support est soutenue contre la surface de paroi de la rainure de rail (125a), et dans lequel la pièce de couplage (121c) est mise en prise avec une rainure (125b) positionnée au côté arrière du logement parmi les rainures (125b).

9. Terminal portable (100) selon la revendication 8, dans lequel l'autre portion du rail de guidage (117a) se trouve à une position opposée à une portion de la partie de support (121b).

10. Terminal portable (100) selon l'une quelconque des revendications 1 à 9, dans lequel l'organe de boîtier (102) comprend en outre :
une surface en escalier (125d) formée d'un côté de la rainure de rail (125a),
dans lequel la surface en escalier (125d) est conçue pour soutenir le couvercle arrière (101b) à partir de la direction vers l'arrière du logement (101) en contact étroit avec le couvercle avant (101a).

11. Terminal portable (100) selon l'une quelconque des revendications 1 à 9, dans lequel l'organe de boîtier (102) est couplé de manière à pouvoir coulisser du côté supérieur au côté inférieur du logement (101).

12. Terminal portable (100) selon la revendication 11, dans lequel l'extrémité supérieure de l'organe de boîtier (102) est ouverte pour exposer la portion d'extrémité supérieure du logement (101).

13. Terminal portable (100) selon la revendication 12, comprenant en outre :
un organe de couvercle (193) à coupler à l'extrémité supérieure du logement (101), dans lequel l'organe de couvercle (193) est conçu pour fixer l'organe de boîtier (102) sur le logement (101).

14. Terminal portable (100) selon la revendication 13, comprenant en outre :
un couvercle de décoration (195) à attacher à la surface extérieure de l'organe de couvercle (193).

15. Terminal portable (100) selon la revendication 14, comprenant en outre :
au moins un connecteur à disposer à l'extrémité supérieure du logement (101), dans lequel l'organe de couvercle (193) et le couvercle de décoration (195) comprennent en outre des trous pour exposer le connecteur.
